# EUROPEAN PATENT APPLICATION

(11) **EP 4 576 188 A1**
(43) Date of publication of application: **25.06.2025**
(21) Application number: 23217449.0
(22) Date of filing: 18.12.2023
(51) Int. Cl.: H01L 21/822, H01L 21/8238, H01L 27/06, H01L 27/092, H01L 29/06, H01L 29/775

(54) **CFET STRUCTURE AND METHOD OF FABRICATING A CFET STRUCTURE**

(71) Applicant: IMEC VZW, 3001 Leuven (BE)
(72) Inventor: Mirabelli, Gioele, 3000 Leuven (BE); Van de Put, Maarten, 1840 Londerzeel (BE); Hellings, Geert, 1500 Halle (BE)
(74) Representative: Roth, Sebastian

(57) **Abstract**

The disclosure relates to a CFET structure (10). The CFET structure (10) comprises at least one CFET element comprising a first transistor structure (21), and a second transistor structure (22) which is arranged above the first transistor structure (21) and which comprises a source and/or drain structure (12b). The CFET structure (10) further comprises a power rail (14) arranged below the first transistor structure (21) of the at least one CFET element; and a power routing line (16) arranged above the second transistor structure (22) of the at least one CFET element, wherein the power routing line (16) is electrically connected to the source and/or drain structure (12b) of the second transistor structure (22) from the top; wherein the at least one CFET element further comprises a tap connection structure (23) which is arranged to electrically connect the power rail (14) with the source and/or drain structure (12b) of the second transistor structure (22); wherein the tap connection structure (23) is arranged to bypass the first transistor structure (21) on one side.

## Description

### TECHNICAL FIELD

The present disclosure refers to a complementary field effect transistor (CFET) structure and to a method of fabricating such a CFET structure.

### BACKGROUND

In a CFET device, different transistor structures, particularly NMOS and PMOS transistors, may be stacked on top of each other compared, for example, to a nanosheet device, which comprises NMOS and PMOS transistors arranged side by side with a spacing in between them. The stacking of the transistor structures in the CFET device enables increasing an effective channel width.

A CFET device can contain many CFET cells which can be formed by a number of stacked NMOS and PMOS transistors. The CFET cells can form logic cells of the CFET device (e.g., inverter cells or NAND cells). An exemplary implementation of a CFET cell may comprise two NMOS transistor structures and two PMOS transistor structures which are processed in a stacked manner.

An issue in an exemplary conventional CFET devices is related to the power supply to the stacked transistor structures. Depending on the configuration, a bottom transistor structure is supplied by a VDD voltage while a top transistor structure (above the bottom structure) is supplied by a VSS voltage, or vice versa. The VSS and VDD voltages are typically provided by buried power rails (BPR) which are arranged below the CFET cells. However, it is difficult to route the power supply from such a BPR to the top transistor structures.

A possible solution for supplying the top transistor structures are so-called tap cells. Tap cells are dedicated cells which connect a back side power supply to a local power supply of a cell, e.g., a BPR or a metal intermediate (Mint) VSS. However, tap cells are usually arranged in regular columns covering the whole height of the chip and require a significant portion of the overall CFET device area (typically 4-5%). This causes an area penalty and reduces the total number of otherwise usable CFET logic cells.

### SUMMARY

Thus, it is an objective to provide an improved CFET structure and an improved method of fabricating a CFET structure. In particular, the above-mentioned disadvantages should be avoided.

The objective is achieved by the embodiments provided in the enclosed independent claims. Advantageous implementations of the embodiments of the disclosure are further defined in the dependent claims.

A first aspect of this disclosure provides a complementary field effect transistor (CFET) structure. The CFET structure comprises at least one CFET element comprising: a first transistor structure, and a second transistor structure which is arranged above the first transistor structure and which comprises a source and/or drain structure. The CFET structure further comprises: a power rail arranged below the first transistor structure of the at least one CFET element; and a power routing line arranged above the second transistor structure of the at least one CFET element, wherein the power routing line is electrically connected to the source and/or drain structure of the second transistor structure from the top; wherein the at least one CFET element further comprises a tap connection structure which is arranged to electrically connect the power rail with the source and/or drain structure of the second transistor structure; wherein the tap connection structure is arranged to bypass the first transistor structure on one side.

This achieves the advantage that a power supply to the top transistor structures of the CFET structure is facilitated. In particular, the power supply can be routed from the power rail on a backside to the power routing line on a front side of the CFET structure. The power routing line can in-turn supply a number of (top) transistor structures of various CFET elements of the CFET structure. The CFET element which comprises the tap connection structures can otherwise maintain their full logic functionality in a CFET cell. In particular, no dedicated tap cells are required in the CFET structure.

The power rail can be a backside power rail. The power rail can be a VSS or VDD power rail. Thus, the power rail can supply a VSS or VDD voltage to the second transistor structure and to the top power routing line via the tap connection structure.

For example, a CFET element can have one or a plurality of tap connection structures.

The first transistor structure can be a bottom transistor structure and the second transistor structure can be a top transistor structure. For example, the first (or bottom) transistor structure is arranged in a first tier (or level) and the second (or top) transistor structure is arranged in a second tier (or level) of the CFET structure, wherein the second tier is arranged above the first tier. This may result in stacked transistor structures of the CFET structure. The first and second transistor structure can further comprise respective channel layers as well as gate structures and source/drain structures alternatively arranged along a channel direction.

The first and second transistor structure of the CFET element may be vertically aligned (i.e., directly on top of each other with no vertical displacement). The CFET element may comprise further transistor structures or other elements, which could respectively be directly above or beneath the first and second transistor structure.

The CFET element can be a CFET cell or can be a part of a CFET cell. For instance, the transistor structures of the CFET element can be components of the CFET cell.

The CFET cell can form a logic cell or a unit cell of the CFET structure (e.g., an inverter or NAND cell). The CFET structure may comprise a plurality of CFET elements and/or CFET cells.

Notably, in this disclosure the terms "below" and "above", "bottom" and "top", "front(side)" and "back(side)", or similar terms are to be interpreted relative to each other. In particular, these terms describe opposite sides of the CFET structure, or opposite sides of any element of the CFET structure. The terms may describe a relationship of elements (e.g., transistor structures, signal routing lines, power rails, etc.) of the CFET structure along the direction of stacking of the tiers (or levels) of the CFET structure. The stacking direction may thus align with the arrangement of the two tiers (or even more than two tiers) of the CFET structure. That is, the two or more tiers (or levels), which are arranged above each other, are arranged one after the other along a certain direction (the stacking direction).

A transistor structure in this disclosure may be or may comprise a transistor, for example a field effect transistor (FET), or may be or may comprise a more complex semiconductor-based structure, which functions like a transistor. For instance, the semiconductor-based structure may be a nanosheet structure, a fin structure, or a forksheet structure, for example, provided with a gate partly wrapping around or fully wrapping around channel portions. The latter may be a gate-all-around structure.

The transistor structures of the CFET structure of the first aspect may be NMOS and PMOS transistor structures. For instance, the first transistor structure may be an NMOS transistor structure and the second transistor structure a PMOS transistor structure, or vice versa.

In an embodiment, the tap connection structure comprises a vertical line structure. For example, the tap connection structure is formed by a metallic via. The line structure can be tapered towards the power rail.

In an embodiment, a section of the source and/or drain structure of the second transistor structure protrudes beyond the first transistor structure of the CFET element; wherein the tap connection structure contacts the protruding section of the source and/or drain structure from the bottom. This achieves the advantage that the tap connection structure can bypass the first (bottom) transistor structure of the CFET element.

For example, the source and/or drain structure of the second transistor structure protrudes beyond a source and/or drain structure of the first transistor structure. This may be referred to as a staggered arrangement.

In an embodiment, the CFET structure further comprises a further connection structure which is arranged to electrically connect the power routing line and the source and/or drain structure of the second transistor structure. For example, the further connection structure is a short metallic via.

In an embodiment, the power rail is connected to a backside power delivery network (BSPDN) of the CFET structure. The BSPDN can be arranged below the first transistor structure.

In an embodiment, the CFET structure further comprises a dielectric wall; wherein the first and the second transistor structure of the at least one CFET element are arranged on one side of the dielectric wall. For example, the CFET structure can be based on a forksheet architecture.

In an embodiment, the power routing line is arranged directly above the dielectric wall and runs in parallel to the dielectric wall.

For instance, top transistor structures on both sides of the dielectric wall can be supplied by the same power routing line. In this way, the number of required power routing lines can be reduced.

In an embodiment, the CFET structure comprises a further power rail arranged below the first transistor structure of the at least one CFET element; wherein the further power rail is electrically connected to a source and/or drain structure of the first transistor structure from the bottom.

Thus, the first (bottom) transistor structure can receive its power supply (e.g., VDD) from the bottom, and the second (top) transistor device can receive its power supply (e.g., VSS) from the top. This provides the advantage that the CFET structure, in particular the CFET element, can be more compact. Furthermore, this can facilitate the additional use of side-routing structures in the CFET element.

The further power rail can supply a VDD or VSS voltage to the first (bottom) transistor structure. The further power rail can be a backside power rail or the BSPDN.

In an embodiment, the at least one CFET element further comprises a side routing structure which is arranged to electrically connect the first transistor structure with a third transistor structure of the CFET element which is arranged above the first transistor structure; wherein the side routing structure is arranged on the same side of the CFET element as the tap connection structure and is not in physical contact with the tap connection structure.

In particular, the third transistor structure is not arranged directly on top of the first transistor structure.

In an embodiment, the CFET structure further comprises at least one further CFET element which is electrically connected to the power routing line; wherein the at least one further CFET element is not directly connected to the power rail.

This further CFET element can receive a power supply (e.g., VSS or VDD voltage) from the (top) power routing line and therefore does not need a direct connection to the (bottom) power rail.

Hereby, "direct connection" may refer to a connection via a dedicated electrical link of the CFET element (e.g., the tap connection structure). The at least one further CFET element is not directly connected to the power rail, but could be considered indirectly connected to the power rail via the S/D structure of the second transistor structure and the tap connection structure of the CFET element which is connected to the same power routing.

In an embodiment, the at least one further CFET element does not comprise a dedicated tap connection structure which electrically connects the at least one further CFET element to the power rail.

Thus, tap connection structures are not required in all CFET elements of a larger CFET structure. It can be sufficient if only a fraction of the CFET elements comprise a respective tap connection structure while the remaining CFET elements (without a tap connection structure) are only connected to and supplied by the power routing line above.

In an embodiment, between 65% and 95%, preferably between 75% and 85%, of the total number of CFET elements of the CFET structure comprise a respective tap connection structure.

The exact number of CFET elements with and without tap connection structures may depend on the exact design of the CFET structure and/or the types of CFET elements used, and might vary from device to device.

A second aspect of this disclosure provides a method of fabricating a complementary field effect transistor, CFET, device. The method comprises forming at least one CFET element comprising: a first transistor structure, and a second transistor structure which is arranged above the first transistor structure and which comprises a source and/or drain structure. The method further comprises: forming a power rail below the first transistor structure of the at least one CFET element; forming a power routing line above the second transistor structure of the at least one CFET element, wherein the power routing line is electrically connected to the source and/or drain structure of the second transistor structure from the top; and forming a tap connection structure of the at least one CFET element which electrically connects the power rail with the source and/or drain structure of the second transistor structure, wherein the tap connection structure is arranged to bypass the first transistor structure on one side.

This achieves the advantage that a power supply to the top transistor structures of the CFET structure is facilitated. In particular, the power supply can be routed from the power rail to the power routing line which can in-turn supply multiple (top) transistor structures of the CFET structure. The CFET element which comprises the tap connection structures can otherwise maintain its full functionality and no dedicated tap cells are required.

In an embodiment, the method further comprises: forming a further connection structure which electrically connects the power routing line and the source and/or drain structure of the second transistor structure.

In an embodiment, the method further comprises: forming at least one further CFET element which is electrically connected to the power routing line; wherein the at least one further CFET element is not directly connected to the power rail.

In an embodiment, the at least one further CFET element does not comprise a dedicated tap connection structure which electrically connects the at least one further CFET element to the power rail.

In an embodiment, between 65% and 95%, preferably between 75% and 85%, of the total number of CFET elements of the CFET structure comprise a respective tap connection structure.

In an embodiment, the tap connection structure comprises a vertical line structure.

In an embodiment, a section of the source and/or drain structure of the second transistor structure protrudes beyond the first transistor structure of the CFET element; wherein the tap connection structure contacts the protruding section of the source and/or drain structure from the bottom.

In an embodiment, the power rail is connected to a BSPDN of the CFET structure.

In an embodiment, a dielectric wall is formed; wherein the first and the second transistor structure of the at least one CFET element are arranged on one side of the dielectric wall.

In an embodiment, the power routing line is arranged directly above the dielectric wall and runs in parallel to the dielectric wall.

In an embodiment, further power rail is formed below the first transistor structure of the at least one CFET element; wherein the further power rail is electrically connected to a source and/or drain structure of the first transistor structure from the bottom.

In an embodiment, comprises a side routing structure is formed to electrically connect the first transistor structure with a third transistor structure of the CFET element which is arranged above the first transistor structure; wherein the side routing structure is arranged on the same side of the CFET element as the tap connection structure and is not in physical contact with the tap connection structure.

### BRIEF DESCRIPTION OF THE DRAWINGS

The above described aspects and implementations are explained in the following description of embodiments with respect to the enclosed drawings:
- FIGS. 1A-B: show schematic views of a CFET structure according to an embodiment;
- FIGS. 2A-B: show schematic views of a CFET structure according to an embodiment;
- FIGS. 3A-B: show schematic views of a CFET structure according to an embodiment;
- FIGS. 4A-B: show schematic top views of different CFET structures according to an embodiment;
- FIGS. 5A-B: show the results of simulations with different CFET structures according to an embodiment;
- FIG. 6: shows a schematic diagram of a CFET structure according to an embodiment; and
- FIGS. 7A-C: show steps of a method of fabricating a CFET structure according to an embodiment.

### DETAILED DESCRIPTION OF EMBODIMENTS

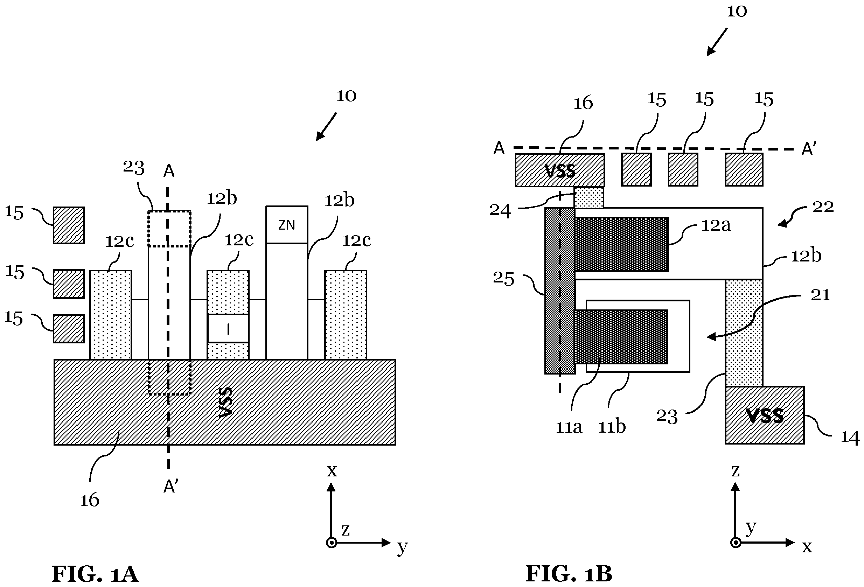

FIGS. 1A and 1B show schematic views of a CFET structure 10 according to an embodiment. Thereby, FIG. 1A shows a top view and FIG. 1B shows a cross-sectional view of the same CFET structure 10, wherein the section lines A-A' indicate the position of the cross-section.

The CFET structure 10 comprises at least one CFET element, the CFET element comprising: a first transistor structure 21, and a second transistor structure 22 which is arranged above the first transistor 21 structure and which comprises a source and/or drain structure 12b. The CFET structure 10 further comprises a power rail 14 arranged below the first transistor structure 21 of the at least one CFET element; and a power routing line 16 arranged above the second transistor structure 22 of the at least one CFET element, wherein the power routing line 16 is electrically connected to the source and/or drain structure 12b of the second transistor structure 22 from the top. The at least one CFET element further comprises a tap connection structure 23 which is arranged to electrically connect the power rail 14 with the source and/or drain structure 12b of the second transistor structure 22; wherein the tap connection structure 23 is arranged to bypass the first transistor structure 21 on one side.

Hereby, the relative terms "top" and "bottom" (or "above" and "below") indicate a vertical arrangement along a z-direction, as indicated by the Cartesian coordinate system. For instance, the first transistor structure 21 can be a bottom transistor structure and the second transistor structure 22 can be a top transistor structure.

The CFET element can form a CFET cell, e.g. a logic cell, or can be a part of such a CFET cell. The CFET element can comprise a number of first (bottom) transistor structures 21 and second (top) transistor structures 22, wherein the second transistor structures 22 are arranged above the first transistor structures 21. For example, the first (bottom) transistor structures 21 are arranged in a first tier or level of the CFET structure 10 and the second (top) transistor structures 22 are arranged in a second tier or level of the CFET structure 10, above the first tier.

The size of the CFET element and, in particular, the number of its first and second (or bottom and top) transistor structures 21, 22 can depend on its function. For instance, the CFET element of the CFET structure 10 in FIGS. 1A-B is an inverter (INV) cell which comprises one first transistor structure 21 and one second transistor structure 22.

The first transistor structure 21 and the second transistor structure 22 can each comprise a respective channel structure 11a, 12a, wherein each channel structure 11a, 12a can comprise a number of channel layers (which are extending along a y-axis, as indicated by the coordinate system). Furthermore, each of the first transistor structure 21 and the second transistor structure 22 can comprise at least two source and/or drain structures 11b, 12b and a gate structure 12c. The source and/or drain structures 11b, 12b can be formed from metal zero (Mo) layers, e.g., the top source and/or drain structures 12b from a MoAT layer and the bottom source and/or drain structures 11b from a MoAB layer. The top source and/or drain structures 12b can comprise a source and/or drain extension which is contacted by the tap connection structure 23. The gate structure 12c can be a common gate structure of the bottom and top transistor structures 21, 22.

The CFET structure 10 can comprise a number of signaling lines 15 which are arranged above the second transistor structure 22. The CFET element can be connected to individual signaling lines via an input I and an output ZN, as shown in in FIG. 1A. The signaling lines 15 and the power routing line 16 can be formed from horizontal metal layers, e.g. metal intermediate (Mint) layers. The power routing line 16 can be arranged adjacent to the signaling lines 15, e.g., in the same plane.

As shown in FIGS. 1A and 1B, the power rail 14 can supply a VSS voltage to the second (top) transistor structure 22 and to the top power routing line via the tap connection structure 23. Alternatively, the power rail 14 could also supply a VDD voltage.

The tap connection structure 23 can comprises a vertical line structure, for example a metallic via. While the cell in FIGS. 1A-B has one tap connection structure, bigger CFET elements could comprise multiple tap connection structures 23.

As shown in FIG. 1B, a section of the source and/or drain structure 12b of the second transistor structure 22 can protrude beyond the first transistor structure 21 below (in x-direction). The tap connection structure 23 can contact this protruding section of the source and/or drain structure 12b from the bottom. In this way, it can bypass the first transistor structure 21. For instance, the source and/or drain structures 11b, 12b of the first and second transistor structure 21, 22 can be arranged in such a staggered configuration (e.g., staggered in the x-z plane), to allow the tap connection structure 23 to bypass the bottom source and/or drain structures 11b and, thus, the first (bottom) transistor structure 21.

The CFET element can comprise a further connection structure 24 which is arranged to electrically connect the power routing line 16 with the source and/or drain structure 12b of the second transistor structure 22. In this way, the supply voltage (VSS or VDD) can be routed from the power rail 14 via the tap connection structure 23, the source and/or drain structure 12b and the further connection structure 24 to the power routing line 16. For example, the further connection structure 24 can be a short metallic via.

The tap connection structure 23 allows connecting the (bottom) power rail 14 with the (top) power routing line 16 while keeping the logic function of the cell (which comprises the CFET element) fully intact. In particular, there is no more need for dedicated tap cells to establish such a front-to-back connection.

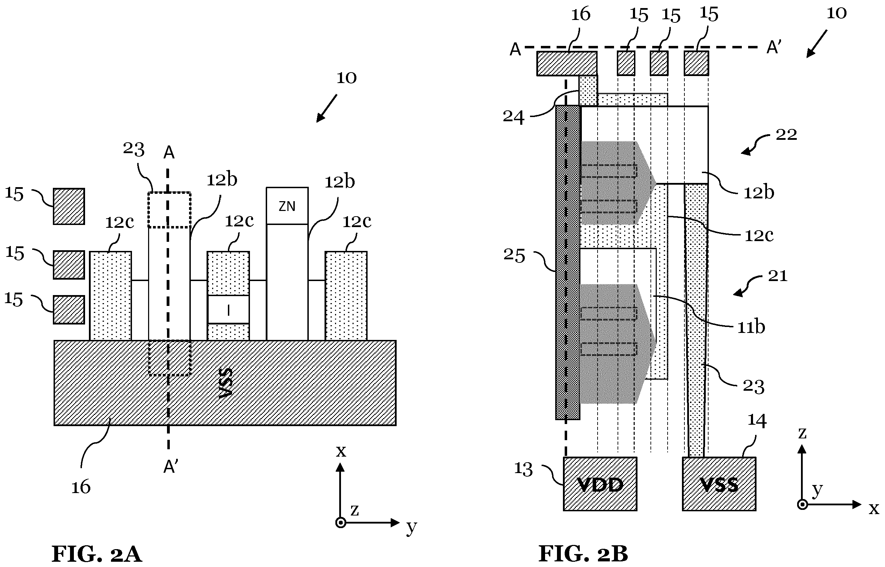

FIGS. 2A and 2B a top view and a cross-sectional view of the CFET structure 10 according to an embodiment. The CFET structure 10 in FIGS. 2A-2B (as well as the structure 10 in FIGS. 1A-B) has a forksheet architecture, i.e., it comprises a dielectric wall 25, wherein transistor structures (e.g., NMOS and PMOS structures) can be arranged on both sides of the wall 25.

In FIG. 2B, the first and the second transistor structure 21, 22 of the at least one CFET element are arranged on one side of the dielectric wall 25. The transistor structures on the opposite side of the dielectric wall are not shown.

The dielectric wall 25 can support a number of nanosheet layers, which comprise the channel layers of the transistor structures 21, 22. The two gray areas around some of the nanosheet layers in FIG. 2B can indicate an active nanosheet part of the first and second transistor structure 21, 22.

As shown in FIG. 2B, the power rail 14 can be connected to a backside power delivery network (BSPDN) of the CFET structure 10. This BSPDN can comprise a further power rail 13 which is also arranged below the first transistor structure 21 and which is electrically connected to a source and/or drain structure 11b of the first transistor structure 21 from the bottom.

For instance, the (top) power routing line 16 can be arranged directly above the dielectric wall and can run in parallel to the dielectric wall (along the y-axis, as indicated by the coordinate system). In this way, (top) transistor structures which are arranged on both sides of the dielectric wall can be supplied by the same power routing line 16.

The further power rail 13 can be arranged directly below the first transistor structure 21, in particular the source and/or drain structure 11b of the first transistor structure 21 (i.e., without lateral displacement).

For instance, the power rail 14 can supply a VSS supply voltage and the further power rail 13 can supply a VDD supply voltage, or vice versa.

Supplying the first (top) transistor structure 21 from the bottom and the second (bottom) transistor structure 22 from the top allows for a compact design of the CFET element. Furthermore, such a cell can be better co-integrated with side routing.

Having a dedicated power line 16 for either VSS or VDD on a top side of the CFET structure 10 (i.e., above the top transistor structure 22), offers certain advantages, such as easier processing and wider active width with respect to conventional architectures that use tall and wide vias for connecting a BSPDN to a top device or a backside power rail to provide power to the top transistor device 22.

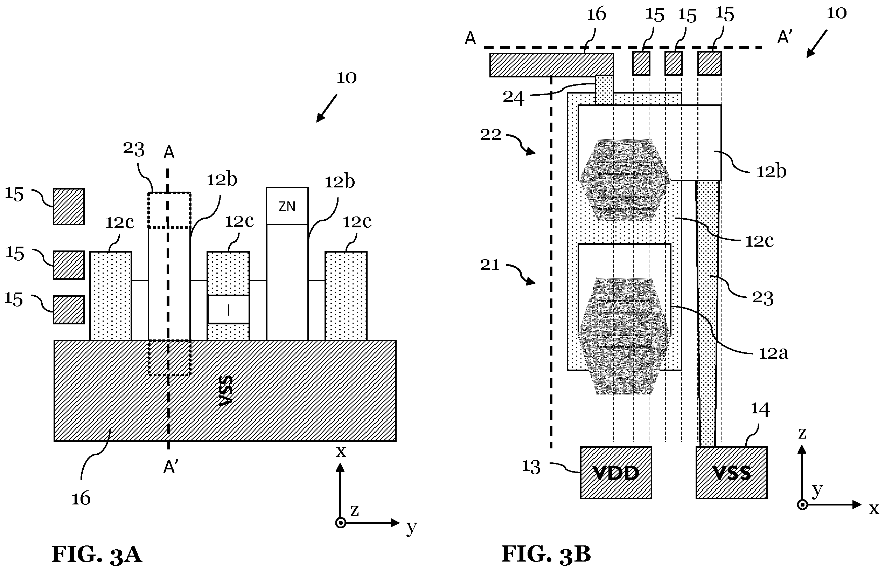

FIGS. 3A and 3B show a top view and a cross-sectional view of the CFET structure 10 according to a further embodiment. Thereby, the CFET structure 10 has a nanosheet architecture without a dielectric wall 25. In the nanosheet architecture, the gate can surround the channel layers of the channel structures 11a, 12a on all sides (gate all around).

As can be seen in all FIGS. 1A-3B, the power routing line 16 can be wider than the signaling lines 15 and/or can be arranged laterally displaced to one side of the CFET element, facilitating the connection of CFET elements on both sides of the power routing line 16 (in x-direction) to the power routing line 16. Furthermore, a plurality of CFET elements which are arranged along the power routing line 16 (along the y-axis or channel direction) can be connected to the power routing line 16.

The tap connection structure 23 can connect a MoAT layer (top source / drain 12b) with the BSPDN, in this way connecting the frontside rail 16 (also: power routing line) to the power rail 14 of the BSPDN. Such a design does not require conventional tap cells.

The FIGS. 1A-3B show CFET structures 10 with an inverter cell (INVD1). In each case, the tap connection structure 23 can be arranged in an area of this inverter cell which is otherwise not used, i.e., not occupied by another structure. For instance, the tap connection structure 23 can be arranged adjacent to a top source and/or drain structure 12b, which is also connected to the power routing line 16, as shown by the dashed rectangle 23 in FIGS. 1A, 2A and 3A. Alternatively, the tap connection structure 23 could be arranged in other areas of a CFET element, where there is an "empty" area which is not occupied by another structure.

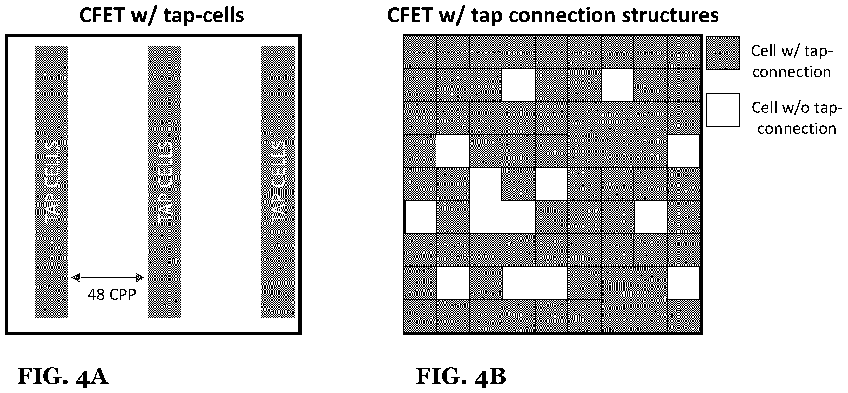

FIGS. 4A and 4B compare a conventional CFET design to a CFET structure 10 which comprise tap connection structures 23 (as e.g., shown in any one of FIGS. 1A-3C). Both of these CFET designs feature an architecture with a front-side power supply for the respective top transistor structures via a power line or rail arranged above the top transistors. In general, such a front-side power supply allows for easier processing and a wider active area with respect to other power delivery options. In the conventional CFET structure, the front-side power delivery requires special cells, so-called tap cells. These taps cells provide an electrical connection of the backside power rail to a frontside rail.

FIG. 4A shows a schematic top view of the conventional CFET structure with tap cells. To reduce the resistivity, the tap cells are typically placed in regularly arranged columns and at a certain fixed distance (e.g., at a distance of 48 CPP = Contacted Poly Pitch). This periodic arrangement reduces the voltage drop across the VSS line in the FEOL (front-end-of-line). The tap cells can occupy between 4% and 5% of the total design area. Thus, the tap cells cause an area penalty, because the area which is occupied by the tap cells cannot be used by other (logic) cells of the CFET. For instance, a tap cell can comprise a contact structure (e.g., a MoAT layer) which is arranged between two dummy gate structures in close proximity to a top channel structure. This contact structure can be electrically connected to the power rail 14 below.

In contrast, FIG. 4B shows a schematic top view of a CFET structure 10 (as e.g., shown in FIGS. 1A-3C) which comprises a plurality of cells with tap connection structures 23 instead of tap cells. As shown in FIG. 4B, the tap connection structures 23 can be directly integrated in at least a fraction of the CFET elements (as indicated by the black boxes). The CFET elements with the tap connection structures 23 can still maintain their main function as logic cells (e.g., inverter cells) and/or standard cells (or parts of such cells). For instance, the cells with tap connection structures 23 can be of different types and can have varying sizes.

The CFET elements with tap connection structures 23 do not have to be arranged periodically as the tap cells, and can be distributed randomly instead.

The CFET structure 10 can comprise further CFET elements (indicated by white boxes in FIG. 4B) which do not comprise dedicated tap connection structures 23 and are thus not directly connected to the power rail 14 below. These further CFET elements, in particular their respective second (top) transistor structures 22, can however be connected to the power routing line 16 above and receive the supply voltage (VSS or VDD) from this line 16.

For instance, these further CFET elements do not allow for tap connection structures 23 due to their configuration and/or arrangement (e.g., cells with multiple input or output signals), but can still receive the supply voltage from the top thus benefitting from the tap connections structures 23 of other CFET elements (e.g., INVDX/BUFFDX cells with X>2) which bring the supply voltage to the power routing line 16.

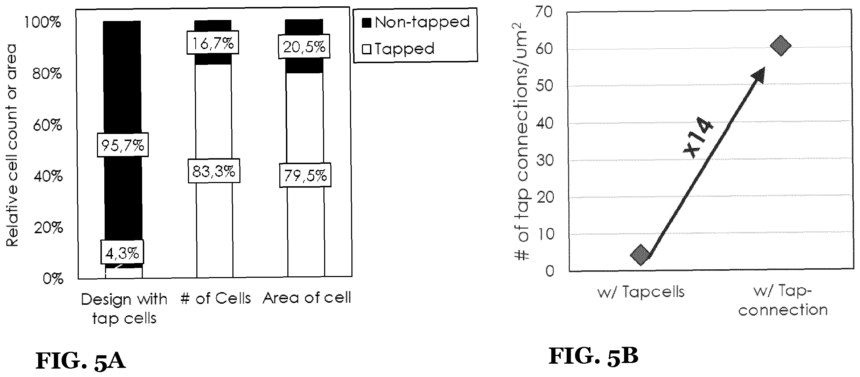

FIGS. 5A-B show the results of simulations with different CFET structures according to an embodiment. In particular, FIGS. 5A and 5B compare the results of block level place and route simulations of a conventional CFET design featuring tap cells with a CFET design featuring the tap connection structures 23.

The chart in FIG. 5A shows a relative cell count or cell area of taped and non-tapped cells. In the conventional design (left bar), ca. 4-5% of cells are tap cells. However, in a CFET structure 10 as e.g. shown in any one of FIGS. 1A-3C, the majority of cells can have a tap connection structure 23.

In the simulated example, ca. 83% of cells can have a tap connection structures 23 making up an area of ca. 80% of the total cell area (middle and right bar in FIG. 5A). Thus, as shown in FIG. 5B, the number of tap connections per µm² can be 14 times higher when using tap connections structures 23 as compared to a conventional CFET design with tap cells.

These simulation results demonstrate the advantages of integrated tap connection structures 23, as the high density of the front-to-backside connections results in a more stable power supply to the front-side (in addition to the area scaling benefit).

Thereby, the exact number of CFET elements with and without tap connection structures 23 can vary, e.g., depending on the type and size of cells. For instance, between 65% and 95%, preferably between 75% and 85%, of the total number of CFET elements of the CFET structure 10 can comprise at least one tap connection structure 23.

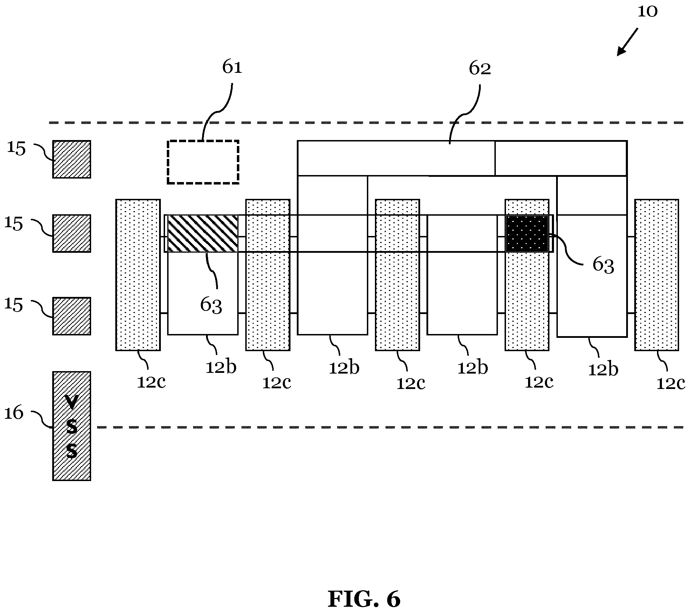

FIG. 6 shows a schematic diagram of a CFET structure 10 according to an embodiment. The CFET structure 10 comprises a CFET element which has at least an additional third transistor structure in a level above the first transistor structure 21 and adjacent to the second transistor structure 22. I.e., the third transistor structure is an additional top transistor structure of the cell.

The CFET element in FIG. 6 further comprises a side routing structure 62 which electrically connects the first transistor structure 21 with the third transistor structure 22 (which is not necessarily directly on top of the first transistor structure 21).

The tap connection structure 23 (which is connected to the second transistor structure 22) can be arranged on the same side of the CFET element as the side routing structure and is thereby not in physical contact with the side routing structure 62. For instance, the tap connection structure 23 is arranged in an empty space on the side of the CFET element which is not occupied by any other structure (e.g., the space 61 indicated by a dashed rectangle in FIG. 6).

For instance, the side routing structure 62 can contact a S/D structure of a bottom transistor structure and a S/D structure of a top transistor structure from one side and, in this way, electrically connect the top and bottom transistor structure. Thereby, the S/D structures can be displaced along the channel direction (i.e., not arranged directly on top of each other).

Thus, a tap connection structure 23 can be used in some CFET elements which have a side routing architecture, as long as there is an unoccupied space adjacent to a top transistor structure source or drain 12b.

The CFET element in FIG: 6 further shows possible interconnections 63 of the top transistor structures to a top signal routing line 15 and/or to each other. The exact configuration and arrangement of such interconnections can depend on the cell type.

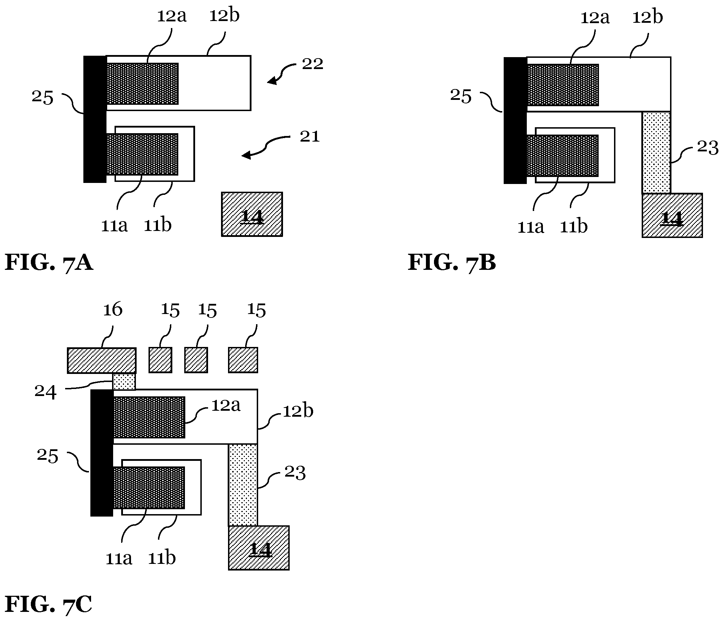

FIGS. 7A-C show steps of a method of fabricating a CFET structure 10 according to an embodiment. Thereby, the sequence of the fabrication steps as shown in FIGS. 7A-C and as discussed in the following is only an example. A different sequence for forming the various elements could be used, depending on the fabrication techniques. The general steps of this method could be used to fabricate any one of the CFET structures 10 as shown in FIGS. 1A-3C.

The method comprises the step of forming the power rail 14, e.g. in the form of a backside power rail. For instance, the power rail 14 can be a component of a larger BSPDN which can also comprise the further power rail 13.

The method comprises the further step of forming the at least one CFET element above the power rail 14. The CFET element comprises the first transistor structure 21 and the second transistor structure 22 which is arranged above the first transistor structure 21 and which comprises a source and/or drain structure 12b. In particular, both transistor structures 21, 22 comprise a respective source and/or drain structure 11b, 12b and a respective channel structure 11a, 12a.

The transistor structures 21, 22 can be formed on one side of a dielectric wall 25, as shown in FIG. 1A. This results in a CFET structure 10 with a forksheet design. Alternatively, the dielectric wall 25 could be omitted and the CFET structure 10 could be fabricated in a nanosheet design as, e.g., shown in FIGS. 3A and 3B using the same basic steps.

As shown in FIG. 7B, the method comprises the further step of forming the tap connection structure 23 which electrically connects the power rail 14 with the source and/or drain structure 12b of the second transistor structure 22. Thereby, the tap connection structure 23 is arranged to bypass the first transistor structure on one side.

The highly schematic drawings in FIGS. 7A and 7B show the tap connection structure 23 being formed subsequent to the source and/or drain structure 12b. However, these two elements could be formed together in a complex fabrication process involving a plurality of intermediate steps, such as etching and deposition steps.

Furthermore, as shown in FIG. 7C, the method comprises the step of forming the power routing line 16 above the second transistor structure 22, wherein the power routing line 16 is electrically connected to the source and/or drain structure 12b of the second transistor structure 22 from the top. The power routing line 16 can be formed together with the further signal routing lines 15, e.g., from a further Mint layer.

To electrically connect the power routing line 16 to the source and/or drain structure 12b of the second transistor structure 22, the further connection structure 24 can be formed, e.g., in the form of a short metallic via.

The method can comprise the further step of forming at least one further CFET element which is electrically connected to the power routing line 16. This further CFET element is thereby not directly connected to the power rail, e.g., it does not comprise a dedicated tap connection structure 23. Thus, the CFET structure 10 can comprise CFET elements with and without tap connection structures 23. For instance, the further CFET element could be arranged on an opposite side of the dielectric wall 25.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A complementary field effect transistor, CFET, structure (10), comprising:
at least one CFET element comprising:
- a first transistor structure (21), and
- a second transistor structure (22) which is arranged above the first transistor structure (21) and which comprises a source and/or drain structure (12b);
a power rail (14) arranged below the first transistor structure (21) of the at least one CFET element; and
a power routing line (16) arranged above the second transistor structure (22) of the at least one CFET element, wherein the power routing line (16) is electrically connected to the source and/or drain structure (12b) of the second transistor structure (22) from the top;
wherein the at least one CFET element further comprises a tap connection structure (23) which is arranged to electrically connect the power rail (14) with the source and/or drain structure (12b) of the second transistor structure (22); wherein the tap connection structure (23) is arranged to bypass the first transistor structure (21) on one side.

2. The CFET structure (10) of claim 1,
wherein the tap connection structure (23) comprises a vertical line structure.

3. The CFET structure (10) of claim 1 or 2,
wherein a section of the source and/or drain structure (12b) of the second transistor structure (22) protrudes beyond the first transistor structure (21) of the CFET element;
wherein the tap connection structure (23) contacts the protruding section of the source and/or drain structure (12b) from the bottom.

4. The CFET structure (10) of any one of the preceding claims, further comprising:
a further connection structure (24) which is arranged to electrically connect the power routing line (16) and the source and/or drain structure (12b) of the second transistor structure (22).

5. The CFET structure (10) of any one of the preceding claims,
wherein the power rail (14) is connected to a backside power delivery network, BSPDN, of the CFET structure (10).

6. The CFET structure (10) of any one of the preceding claims, further comprising:
a dielectric wall (25);
wherein the first and the second transistor structure (22) of the at least one CFET element are arranged on one side of the dielectric wall (25).

7. The CFET structure (10) of claim 6,
wherein the power routing line (16) is arranged directly above the dielectric wall (25) and runs in parallel to the dielectric wall (25).

8. The CFET structure (10) of any one of the preceding claims, further comprising:
a further power rail (13) arranged below the first transistor structure (21) of the at least one CFET element;
wherein the further power rail (13) is electrically connected to a source and/or drain structure (11b) of the first transistor structure (21) from the bottom.

9. The CFET structure (10) of any one of the preceding claims,
wherein the at least one CFET element further comprises a side routing structure (62) which is arranged to electrically connect the first transistor structure (21) with a third transistor structure of the CFET element which is arranged above the first transistor structure (21);
wherein the side routing structure (62) is arranged on the same side of the CFET element as the tap connection structure (23) and is not in physical contact with the tap connection structure.

10. The CFET structure (10) of any one of the preceding claims, further comprising:
at least one further CFET element which is electrically connected to the power routing line (16);
wherein the at least one further CFET element is not directly connected to the power rail (14).

11. The CFET structure (10) of claim 10,
wherein the at least one further CFET element does not comprise a dedicated tap connection structure (23) which electrically connects the at least one further CFET element to the power rail (14).

12. The CFET structure (10) of any one of the preceding claims,
wherein between 65% and 95%, preferably between 75% and 85%, of the total number of CFET elements of the CFET structure (10) comprise a respective tap connection structure (23).

13. A method of fabricating a complementary field effect transistor, CFET, device, the method comprising:
forming at least one CFET element comprising:
- a first transistor structure (21), and
- a second transistor structure (22) which is arranged above the first transistor structure (21) and which comprises a source and/or drain structure (12b);
forming a power rail (14) below the first transistor structure (21) of the at least one CFET element;
forming a power routing line (16) above the second transistor structure (22) of the at least one CFET element, wherein the power routing line (16) is electrically connected to the source and/or drain structure (12b) of the second transistor structure (22) from the top; and
forming a tap connection structure (23) of the at least one CFET element which electrically connects the power rail (14) with the source and/or drain structure (12b) of the second transistor structure (22), wherein the tap connection structure (23) is arranged to bypass the first transistor structure (21) on one side.

14. The method of claim 13, further comprising:
forming a further connection structure (24) which electrically connects the power routing line (16) and the source and/or drain structure (12b) of the second transistor structure (22).

15. The method of claim 13 or 14, further comprising:
forming at least one further CFET element which is electrically connected to the power routing line (16);
wherein the at least one further CFET element is not directly connected to the power rail (14).
